# EUROPEAN PATENT SPECIFICATION

(11) **EP 4 191 680 B1**
(45) Date of publication and mention of the grant of the patent: **08.04.2026**
(21) Application number: 21853117.6
(22) Date of filing: 30.07.2021
(51) Int. Cl.: H10D 30/66, H10D 30/01, H10D 62/10, H10D 62/832, H10D 64/27

(54) **CELLULAR STRUCTURE OF SILICON CARBIDE DEVICE, PREPARATION METHOD FOR CELLULAR STRUCTURE OF SILICON CARBIDE DEVICE, AND SILICON CARBIDE DEVICE**
ZELLULARE STRUKTUR EINER SILICIUMCARBIDVORRICHTUNG, HERSTELLUNGSVERFAHREN FÜR DIE ZELLULARE STRUKTUR EINER SILICIUMCARBIDVORRICHTUNG UND SILICIUMCARBIDVORRICHTUNG
STRUCTURE CELLULAIRE DE DISPOSITIF AU CARBURE DE SILICIUM, PROCÉDÉ DE PRÉPARATION DE STRUCTURE CELLULAIRE DE DISPOSITIF AU CARBURE DE SILICIUM ET DISPOSITIF AU CARBURE DE SILICIUM

(30) Priority: 03.08.2020 CN 202010768456
(43) Date of publication of application: 07.06.2023
(73) Proprietor: Zhuzhou CRRC Times Semiconductor Co., Ltd., Zhuzhou, Hunan 412005 (CN)
(72) Inventor: WANG, Yafei, Zhuzhou, Hunan 412005 (CN); LIU, Qijun, Zhuzhou, Hunan 412005 (CN); MA, Yachao, Zhuzhou, Hunan 412005 (CN); LI, Chengzhan, Zhuzhou, Hunan 412005 (CN); LUO, Haihui, Zhuzhou, Hunan 412005 (CN)
(74) Representative: Petraz, Gilberto Luigi
(86) International application number: PCT/CN2021/109440
(87) International publication number: WO 2022/028315

(56) References cited:
- CN-A- 102 299 152
- CN-A- 102 299 152
- CN-A- 105 103 297
- CN-A- 110 098 257
- CN-A- 110 429 129
- CN-A- 110 797 389
- CN-A- 111 933 710
- CN-U- 209 859 916
- US-A1- 2018 240 906
- US-A1- 2020 058 760

## Description

### Field of the Invention

The present disclosure relates to the technical field of semiconductor devices, and in particular, to a cellular structure of a silicon carbide device and a preparation method thereof, and a silicon carbide device.

### Background of the Invention

Silicon carbide (SiC) is a new semiconductor material with a wide band gap, and has excellent physical, chemical and electrical properties. The silicon carbide has a breakdown electric field strength 10 times a breakdown electric field strength of a traditional silicon, a thermal conductivity 3 times a thermal conductivity of silicon, and a higher switching frequency, and can be used to reduce the loss and volume of energy storage elements in a circuit. Theoretically, a silicon carbide device can operate in a high-temperature environment over 600 °C, and has excellent radiation resistance, thereby greatly enhancing high-temperature stability thereof, which enables a silicon carbide-based power semiconductor device to be very attractive and promising in a high-power and high-temperature application environment. A silicon carbide metal-oxide-semiconductor field-effect transistor (MOSFET) has features, such as low on-resistance, fast switching speed, and high-temperature resistance, and has a great application advantage in fields, such as high-voltage inverter, new energy vehicle, and railway transportation.

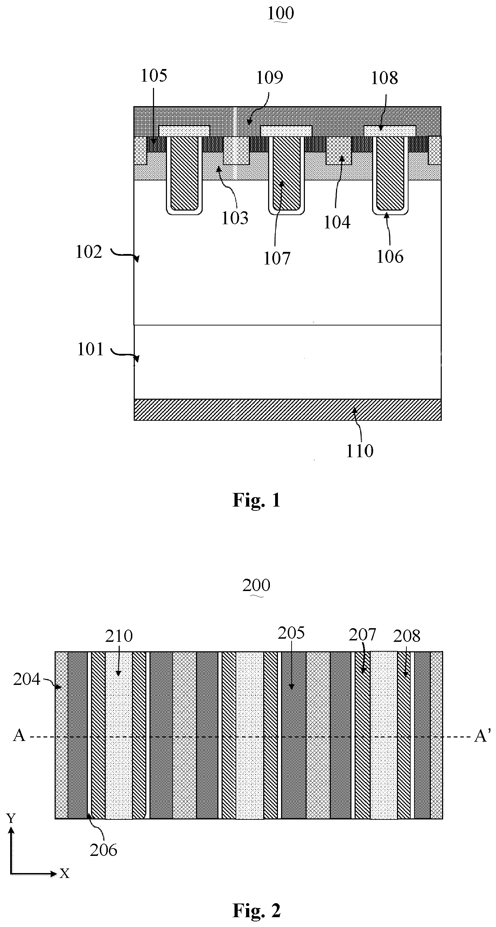

Since a large number of defects occur in an interface between a silicon carbide and a gate oxide layer in a silicon carbide power device (e.g., MOSFET), carrier mobility of a channel is greatly reduced. Anisotropy of a silicon carbide material may be fully utilized by a trench gate silicon carbide device (e.g., MOSFET) to obtain a relatively high carrier mobility of the channel by using a (11 2̅0) crystal plane. A cellular structure 100 of a traditional trench gate silicon carbide device (e.g., MOSFET) is shown in Fig. 1, and includes a substrate 101, a drift layer 102, a well region 103, a first source region 104, which is commonly also called body contact region, a second source region 105, a gate oxide layer 106, a gate electrode 107, an interlayer dielectric layer 108, a source electrode metal layer 109, and a drain electrode metal layer 110. However, a difference between a dielectric constant of a silicon carbide material and a dielectric constant of a gate oxide layer material in the trench gate silicon carbide device (e.g., MOSFET), results in electric field concentration in the gate oxide layer in a blocking state, and then damage to the gate oxide layer and failure and poor reliability of the device.

Document CN110429129 A relates to a power semiconductor device and a preparation method thereof and especially relates to a high-voltage trench-type power semiconductor device and a preparation method thereof and belongs to the technical field of a power semiconductor device. A semiconductor substrate is etched to obtain a wider cell trench; after a substrate conductive polysilicon body filled in the cell trench is etched back, a trench inner injection positioning hole can be obtained in the cell trench, wherein the outer ring of the trench inner injection positioning hole is the substrate conductive polysilicon body; a substrate trench second conductive type doping region and a substrate second conductive type base region can be obtained conveniently at the same time by utilizing the trench inner injection positioning hole; and the substrate trench second conductive type doping region is located directly under the trench bottom of the cell trench and makes contact with the trench bottom of the cell trench.

Document CN102299152 A discloses a double-conduction semiconductor assembly and a manufacturing method thereof. The double-conduction semiconductor assembly comprises an epitaxial layer provided with a first conductive type and provided with a first groove, a first grid conductive layer arranged on one side wall in the first groove, a second grid conductive layer arranged opposite to the first grid conductive layer, and a doped region with the first conductive type. The doped region is arranged in the epitaxial layer between the first grid conductive layer and the second grid conductive layer, and the doping concentration of the doped region is greater than that of the epitaxial layer. Therefore, the conduction resistance of the double-conduction semiconductor assembly is reduced.

Document US2018240906 A1 discloses a switching element, which may include a semiconductor substrate, first and second trenches, a gate insulating layer, an interlayer insulating layer covering the semiconductor substrate, and an electrode on the interlayer insulating layer. A wide portion and a narrow portion may be arranged alternately between the first and second trenches. The interlayer insulating layer may include a contact hole in the wide portion. The electrode may be in contact with the semiconductor substrate within the contact hole. The semiconductor substrate may include an upper n-type region in contact with the gate insulating layer in the narrow portion and in contact with the electrode, a p-type body contact region in contact with the electrode, a p-type body region in contact with the gate insulating layer in the narrow portion, and a lower n-type region in contact with the gate insulating layer in the narrow portion.

### Summary of the Invention

With respect to the above problem, the present disclosure provides a cellular structure of a silicon carbide device and a preparation method thereof, and a silicon carbide device, which solve the problem in related art that, in a silicon carbide device, electric field concentration in a blocking state damages the gate oxide layer and results in failure and poor reliability of the device.

According to a first aspect, the present disclosure provides a cellular structure of a silicon carbide device, according to claim 1.

According to a second aspect, the present disclosure provides a preparation method for the cellular structure of a silicon carbide device of the first aspect, according to claim 5. Preferred embodiments are defined by the dependent claims.

### Brief Description of the Drawings

The accompanying drawings are provided for further understanding of the present disclosure, constitute a part of the description, and are used to explain the present disclosure together with the following specific embodiments, but do not constitute any limitation to the present disclosure, which is only defined by the appended claims. In the drawings:
Fig. 1 schematically shows a sectional view of a cellular structure of a traditional silicon carbide device;
Fig. 2 schematically shows a top view of a cellular structure of a silicon carbide device, according to an example not falling under the scope of the present invention;
Fig. 3 schematically shows a sectional view of a cellular structure of a silicon carbide device, according to an example not falling under the scope of the present invention;
Fig. 4 schematically shows a top view of a cellular structure of another silicon carbide device according to the present invention;
Fig. 5 schematically shows a sectional view of a cellular structure of another silicon carbide device according to the present invention;
Fig. 6 schematically shows a flowchart of a preparation method for a cellular structure of a silicon carbide device, according to an example not falling under the scope of the present invention;
Figs. 7 to 13 schematically show sectional views of structures in relevant steps of a preparation method for a cellular structure of a silicon carbide device according to an, according to an example not falling under the scope of the present invention;
Fig. 14 schematically shows a flowchart of a preparation method for a cellular structure of another silicon carbide device according to the present invention; and
Figs. 15 to 20 schematically show sectional views of structures in relevant steps of a preparation method for a cellular structure of silicon carbide device according to a the present invention.

In the accompanying drawings, like reference numerals are used for like components. The accompanying drawings are not drawn according to actual scale.

### Detailed Description of the Embodiments

The present disclosure will be explained in detail with reference to the accompanying drawings and the embodiments, whereby it can be fully understood how to solve the technical problem by the technical means according to the present disclosure and achieve the corresponding technical effects thereof, and thus the technical solution according to the present disclosure can be implemented. As long as there is no conflict, the embodiments in the present disclosure and the technical features mentioned in the embodiments may be combined with one another, while the scope of protection is only defined by the appended claims. In the accompanying drawings, for clarity, sizes and relative dimensions of layers and regions may be exaggerated, and like reference numerals represent throughout like elements.

It should be understood that, although terms such as "first", "second", and "third" may be used to describe various elements, components, regions, layers, and/or parts, these elements, components, regions, layers, and/or parts shall not be limited by these terms. These terms are used only to differentiate one element, component, region, layer, or part from another element, component, region, layer, or part. Therefore, without departing from teachings of the present disclosure, a first element, a first component, a first region, a first layer, or a first part discussed below may be referred to as a second element, a second component, a second region, a second layer, or a second part.

It should be understood that, terms indicating spatial relationships such as "above", "on", "below", and "under" may be used for the convenience of description herein, so as to describe relationship between one element or feature and another element or feature as shown in the drawings. It should be understood that, in addition to an orientation shown in the drawings, a term indicating a spatial relationship intends to further include a different orientation of a device in use and operation. For example, if a device in the drawing is inverted, an element or feature described as "below another element" may have an orientation described as "above" another element or feature. Therefore, exemplary terms, "below" and "under", may include two orientations. A device may be oriented in another manner (rotated by 90 degrees or orientated otherwise), and a term describing the special relationship used herein would be explained correspondingly.

Terms used herein intend to describe specific embodiments only, and do not intend to limit the present disclosure. When used herein, the singular forms "a", "an" and "the/said" are intended to include the plural forms as well, unless the context clearly indicates otherwise. It should also be understood that, terms "comprise" and/or "include", when used in the description, indicate the existence of the feature, integer, step, operation, element and/or component, but do not exclude the existence or addition of one or more other features, integers, steps, operations, elements, components and/or groups. When used herein, the expression "and/or" includes any or all combinations of relevant listed items.

Embodiments of the present disclosure are described herein with reference to schematic sectional views of ideal embodiments (and intermediate structures) of the present disclosure. In this way, variations from a shape shown due to the preparation technology and/or tolerance can be anticipated. Therefore, embodiments of the present disclosure shall not be limited to a specific shape of a region shown herein, but include a shape deviation caused by the preparation, for example. For example, an implantation region shown as a rectangle may usually have, at its edge, a round or curved feature and/or an implantation concentration gradient, rather than a binary change from an implantation region to a non-implantation region. Likewise, during formation of a buried region by implantation, there may be implantation in regions between the buried region and surfaces passed through when the implantation is performed. Therefore, regions shown in the drawings are substantively schematic, and their shapes do not intend to show actual shapes of regions of a device and do not intend to limit the scope of the present disclosure.

In order to thoroughly understand the present disclosure, detailed structures and steps are provided in the following description, so as to interpret technical solutions of the present disclosure. Preferred embodiments of the present disclosure are described in detail as follows, but the present disclosure may include other embodiments in addition to the detailed description, which do not fall within the scope of the protection.

### Embodiment One

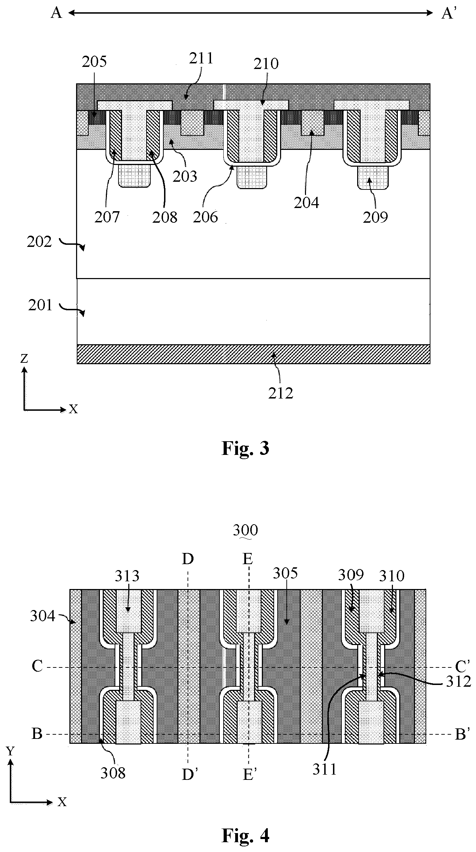

Embodiment One describes an example not falling under the scope of the claimed invention having a gate trench with a single width. As shown in Fig. 2 and Fig. 3, an embodiment of the present disclosure provides a cellular structure 200 of a silicon carbide device, and the cellular structure 200 includes a substrate 201, a drift layer 202, a well region 203, a first source region 204, a second source region 205, a first gate trench (not indicated in the drawings), a gate oxide layer 206, a first gate electrode 207, a second gate electrode 208, a first shielding region 209, an interlayer dielectric layer 210, a source electrode metal layer 211, and a drain electrode metal layer 212.

It should be noted that, in order to clearly show shapes and positions of the first source region 204, the second source region 205, the first gate trench (not indicated in the drawings), the gate oxide layer 206, the first gate electrode 207, the second gate electrode 208, and the interlayer dielectric layer 210 in Fig. 2, the substrate 201, the drift layer 202, the well region 203, the first shielding region 209, the source electrode metal layer 211, the drain electrode metal layer 212, and a part of the interlayer dielectric layer located on the first gate electrode 207 and on the second gate electrode 208 are not show in Fig. 2. However, the shapes and the positions of the substrate 201, the drift layer 202, the well region 203, the first shielding region 209, the source electrode metal layer 211, the drain electrode metal layer 212, and the part of the interlayer dielectric layer on the first gate electrode 207 and on the second gate electrode 208 may be understood with reference to Fig. 3.

Exemplarily, the substrate 201 is a first-conductive-type silicon carbide substrate. The substrate 201 has a relatively great thickness and a relatively high ion doping concentration greater than 1E19 cm⁻³.

The drift layer 202 is a first-conductive-type drift layer, is located on the substrate 201, and has an ion doping concentration in a range from about 1E14 cm⁻³ to 5E16 cm⁻³, and the ion doping concentration may be optimized according to withstand voltage of a chip.

The well region 203 is a second-conductive-type well region. A plurality of well regions 203 are provided at an interval within a surface of the drift layer 202, and an upper surface of the well region 203 is flush with an upper surface of the drift layer 202. The well region 203 has an ion doping concentration in a range from 1E16 cm⁻³ to 5E18 cm⁻³, and has a depth in a range from 0.5 µm to 1.5 µm.

The first source region 204 is a second-conductive-type source region, is located within a surface of the well region 203, and has an upper surface flush with the upper surface of the well region 203. The first source region 204 has a width less than a width of the well region 203, has an ion doping concentration greater than the ion doping concentration of the well region 203, and has a depth less than or equal to the depth of the well region 203. The ion doping concentration of the first source region 204 is greater than 5E18 cm⁻³, and the depth thereof is in a range from 0.5 µm to 1.5 µm.

The second source region 205 is a first-conductive-type source region, is located within the surface of the well region 203 and is provided at two sides of the first source region 204. The second source region 205 has an upper surface flush with the upper surface of the well region 203. An end of the second source region 205 is in contact with the first source region 204, and the other end of the second source region 205 is in contact with the gate oxide layer 206. The second source region 205 has a width less than the width of the well region 203, and has an ion doping concentration greater than the ion doping concentration of the substrate 201. The ion doping concentration of the second source region 205 is greater than 1E19 cm⁻³, and a depth of the second source region 205 is in a range from 0.15 µm to 0.35 µm.

The first gate trench (not indicated in the drawings) is located between two adjacent well regions 203. A sidewall of the first gate trench is in contact with both the well region 203 and the second source region 205. The first gate trench has a depth greater than the depth of the well region 203 by 0.2 µm to 0.5 µm. The first gate trench has a width in a range from 1.0 µm to 3.0 µm. The first gate trench has a relatively small depth-to-width ratio, which is convenient for a fabrication process.

The gate oxide layer 206 is uniformly provided on the sidewall and a bottom of the first gate trench, and has a thickness in a range from 30 nm to 100 nm.

Both the first gate electrode 207 and the second gate electrode 208 are polycrystalline silicon gate electrodes, are provided in the first gate trench, and are respectively located at two sides of the first gate trench. The polycrystalline silicon gate electrodes are made of high-concentration doped polycrystalline silicon, and have an ion doping concentration greater than 1E18 cm⁻³. The first gate electrode 207 and the second gate electrode 208 are isolated by the interlayer dielectric layer 210, and a distance between the first gate electrode 207 and the second gate electrode 208 (a width of the interlayer dielectric layer 210 in the first gate trench) is in a range from 0.5 µm to 2.0 µm. The first gate electrode 207 and the second gate electrode 208 are isolated by both the gate oxide layer 206 and the interlayer dielectric layer 210. That is, the gate electrodes in the first gate trench are split, which can reduce the parasitic capacitance of the gate electrodes.

The first shielding region 209 is a second-conductive-type doping region. The first shielding region 209 is located in the drift layer 202, and is located below the first gate trench. A top of the first shielding region 209 is in contact with a bottom of the first gate trench. The first shielding region 209 has an ion doping concentration greater than 1E18 cm⁻³, and has a junction depth (depth) of 1 µm. The first shielding region 209 is in electrical connection (short connection) with the source electrode metal layer 211 in a three-dimension. The first shielding region 209 can greatly reduce the electric field stress of the gate oxide layer 206 of the device in a blocking state, thereby greatly enhancing the long-term operational reliability of the device.

The interlayer dielectric layer 210 is located on the first gate electrode 207 and on the second gate electrode 208 and in the first gate trench. The interlayer dielectric layer 210 isolates the first gate electrode 207 and the second gate electrode 208 from the source electrode metal layer 211, and isolates the first gate electrode 207 from the second gate electrode 208.

The source electrode metal layer 211 is located on the first source region 204 and on the second source region 205, and is in ohmic contact with both the first source region 204 and the second source region 205. The source electrode metal layer 211 may be made of a metal having a low contact electrical resistivity, such as aluminum.

The drain electrode metal layer 212 is located below the substrate 201, and is in ohmic contact with the substrate 201. The drain electrode metal layer may be made of a metal having a relatively low contact electrical resistivity, such as aluminum.

It should be noted that, the silicon carbide device in the present embodiment is a silicon carbide MOSFET device as an example.

Correspondingly, a first conductive type is opposite to a second conductive type. For example, if the first conductive type is an N type, the second conductive type is a P type; and if the first conductive type is a P type, the second conductive type is an N type.

The present embodiment provides a cellular structure 200 of a silicon carbide device. By providing a second-conductive-type first shielding region 209 at a bottom of a first gate trench, the electric field stress of a gate oxide layer 206 of the device in a blocking state can be greatly reduced, thereby greatly improving the long-term operational reliability of the device. Moreover, by providing, in the gate trench, a first gate electrode 207 and a second gate electrode 208 which are isolated from each other by an interlayer dielectric layer 210, that is, by forming split gate electrodes, the parasitic capacitance of the gate electrodes can be reduced.

### Embodiment Two

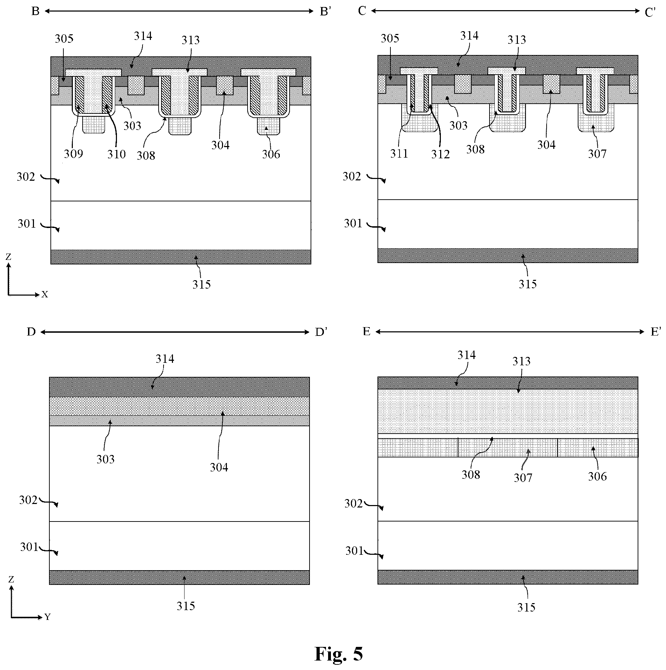

As shown in Fig. 4 and Fig. 5, an embodiment of the present invention provides a cellular structure 300 of a silicon carbide device; and the cellular structure 300 includes a substrate 301, a drift layer 302, a well region 303, a first source region 304, which is commonly also called body contact region, a second source region 305, a first gate trench (not indicated in the drawings), a second gate trench (not indicated in the drawings), a first shielding region 306, a second shielding region 307, a gate oxide layer 308, a first gate electrode 309, a second gate electrode 310, a third gate electrode 311, a fourth gate electrode 312, an interlayer dielectric layer 313, a source electrode metal layer 314, and a drain electrode metal layer 315.

It should be noted that, in order to clearly show shapes and positions of the first source region 304, the second source region 305, the first gate trench (not indicated in the drawings), the second gate trench (not indicated in the drawings), the gate oxide layer 308, the first gate electrode 309, the second gate electrode 310, the third gate electrode 311, the fourth gate electrode 312, and the interlayer dielectric layer 313 in Fig. 4, the substrate 301, the drift layer 302, the well region 303, the first shielding region 306, the second shielding region 307, the source electrode metal layer 314, the drain electrode metal layer 315, and a part of the interlayer dielectric layer on the first gate electrode 309, on the second gate electrode 310, on the third gate electrode 311, and on the fourth gate electrode 312 are not show in Fig. 4. However, the shapes and positions of the substrate 301, the drift layer 302, the well region 303, the first shielding region 306, the second shielding region 307, the source electrode metal layer 314, the drain electrode metal layer 315, and the part of the interlayer dielectric layer located on the first gate electrode 309, on the second gate electrode 310, on the third gate electrode 311, and on the fourth gate electrode 312 can be understood with reference to Fig. 5.

Exemplarily, the substrate 301 is a first-conductive-type silicon carbide substrate. The substrate 301 has a relatively great thickness and a relatively high ion doping concentration greater than 1E19 cm⁻³.

The drift layer 302 is a first-conductive-type drift layer, is located on the substrate 301, and has an ion doping concentration in a range from about 1E14 cm⁻³ to 5E16 cm⁻³, and the ion doping concentration may be optimized according to withstand voltage of a chip.

The well region 303 is a second-conductive-type well region. A plurality of well regions 303 are provided in an interval within a surface of the drift layer 302, and an upper surface of the well region 303 is flush with an upper surface of the drift layer 302. The well region 303 has an ion doping concentration in a range from 1E16 cm⁻³ to 5E18 cm⁻³, and has a depth in a range from 0.5 µm to 1.5 µm.

The first source region 304 is a second-conductive-type source region, is located within the surface of the well region 303, and has an upper surface flush with the upper surface of the well region 303. The first source region 304 has a width less than a width of the well region 303, has an ion doping concentration greater than the ion doping concentration of the well region 303, and has a depth less than or equal to the depth of the well region 303. The ion doping concentration of the first source region 304 is greater than 5E18 cm⁻³, and the depth thereof is in a range from 0.5 µm to 1.5 µm.

The second source region 305 is a first-conductive-type source region, is located within the surface of the well region 303 and is provided at two sides of the first source region 304. The second source region 305 has an upper surface flush with the upper surface of the well region 303. An end of the second source region 305 is in contact with the first source region 304, and the other end of the second source region 305 is in contact with the gate oxide layer 308. The second source region 305 has a width less than the width of the well region 303, and has an ion doping concentration greater than the ion doping concentration of the substrate 301. The ion doping concentration of the second source region 305 is greater than 1E19cm⁻³, and a depth of the second source region 305 is in a range from 0.15 µm to 0.35 µm.

The first gate trench and the second gate trench are provided alternately in a longitudinal direction (i.e., a Y direction) between two adjacent well regions 303. A sidewall of the first gate trench and a sidewall of the second gate trench are in contact with both the well region 303 and the second source region 305. A central axis of the first gate trench in the longitudinal direction ((i.e., the Y direction) coincides with a central axis of the second gate trench in the longitudinal direction ((i.e., the Y direction). Both the first gate trench and the second gate trench have a depth greater than the depth of the well region 303 by 0.2 µm to 0.5 µm. The first gate trench has a width in a range from 1.0 µm to 3.0 µm, and the second gate trench has a width in a range from 0.5 µm to 1.5 µm. The first gate trench has a relatively small depth-to-width ratio, which is convenient for a fabrication process.

The first shielding region 306 is a second-conductive-type doping region. The first shielding region 306 is located in the drift layer 302, and is located below the first gate trench. A top of the first shielding region 306 is in contact with a bottom of the first gate trench. The first shielding region 306 has an ion doping concentration greater than 1E18 cm⁻³, and has a junction depth (depth) of 1 µm. The first shielding region 306 is in electrical connection (short connection) with the source electrode metal layer 314 in a three-dimension. The first shielding region 306 can greatly reduce the electric field stress of the gate oxide layer 308 of the device in a blocking state, thereby greatly improving the long-term operational reliability of the device.

The second shielding region 307 is a second-conductive-type doping region. The second shielding region 307 is located in the drift layer 302, and is located below the second gate trench. A top of the second shielding region 307 is in contact with a bottom of the second gate trench and a bottom of the well region 303. The second shielding region 307 has an ion doping concentration greater than 1E18 cm⁻³, and has a junction depth (depth) of 1 µm. The second shielding region 307 is in electrical connection (short connection) with the source electrode metal layer 314 in a three-dimension. The second shielding region 307 can greatly reduce the electric field stress of the gate oxide layer 308 of the device in a blocking state, thereby greatly improving the long-term operational reliability of the device.

The gate oxide layer 308 is uniformly provided on the sidewall and the bottom of the first gate trench and on the sidewall and the bottom of the second gate trench, and has a thickness in a range from 30 nm to 100 nm.

Both the first gate electrode 309 and the second gate electrode 310 are polycrystalline silicon gate electrodes, are provided in the first gate trench and are respectively located at two sides of the first gate trench. The polycrystalline silicon gate electrodes are made of high-concentration doped polycrystalline silicon, and have an ion doping concentration greater than 1E 18cm⁻³. The first gate electrode 309 and the second gate electrode 310 are isolated from each other by the interlayer dielectric layer 313, and a distance between the first gate electrode 309 and the second gate electrode 310 (a width of the interlayer dielectric layer 313 in the first gate trench) is in a range from 0.5 µm to 2.0 µm. Both the first gate electrode 309 and the second gate electrode 310 are in contact with the gate oxide layer 308 and the interlayer dielectric layer 313. That is, the gate electrodes in the first gate trench are split, which can reduce the parasitic capacitance of the gate electrodes.

Both the third gate electrode 311 and the fourth gate electrode 312 are polycrystalline silicon gate electrodes, are provided in the second gate trench, and are respectively located at two sides of the second gate trench. The polycrystalline silicon gate electrodes are made of high-concentration doped polycrystalline silicon, and have an ion doping concentration greater than 1E18 cm⁻³. The third gate electrode 311 and the fourth gate electrode 312 are isolated from each other by the interlayer dielectric layer 313, and a distance between the third gate electrode 311 and the fourth gate electrode 312 (a width of the interlayer dielectric layer 313 in the second gate trench) is less than the distance between the first gate electrode 309 and the second gate electrode 310 (the width of the interlayer dielectric layer 313 in the first gate trench). The third gate electrode 311 and the fourth gate electrode 312 are in contact with both the gate oxide layer 308 and the interlayer dielectric layer 313. That is, the gate electrodes in the second gate trench are also split, which can reduce the parasitic capacitance of the gate electrodes.

The interlayer dielectric layer 313 is located on the first gate electrode 309, on the second gate electrode 310, on the third gate electrode 311 and on the fourth gate electrode 312, and in the first gate trench and the second gate trench, so as to isolate the first gate electrode 309, the second gate electrode 310, the third gate electrode 311 and the fourth gate electrode 312 from the source electrode metal layer 314, to isolate the first gate electrode 309 from the second gate electrode 310, and to isolate the third gate electrode 311 from the fourth gate electrode 312.

The source electrode metal layer 314 is located on the first source region 304 and on the second source region 305, and is in ohmic contact with both the first source region 304 and the second source region 305. The source electrode metal layer 314 may be made of a metal having a low contact electrical resistivity, such as aluminum.

The drain electrode metal layer 315 is located below the substrate 301, and is in ohmic contact with the substrate 301. The drain electrode metal layer may be made of a metal having a relatively low contact electrical resistivity, such as aluminum.

It should be noted that, the silicon carbide device in the present embodiment is a silicon carbide MOSFET device as an example.

Correspondingly, a first conductive type is opposite to a second conductive type. For example, if the first conductive type is an N type, the second conductive type is a P type; and if the first conductive type is a P type, the second conductive type is an N type.

The present embodiment provides a cellular structure 300 of a silicon carbide device. By providing a second-conductive-type first shielding region 306 at a bottom of a first gate trench and providing a second-conductive-type second shielding region 307 at a bottom of a second gate trench, the electric field stress of a gate oxide layer 308 of the device in a blocking state can be greatly reduced, thereby greatly improving the long-term operational reliability of the device. Moreover, by providing, in the first gate trench, a first gate electrode 309 and a second gate electrode 310 which are isolated from each other by an interlayer dielectric layer 313, and providing, in the second gate trench, a third gate electrode 311 and a fourth gate electrode 312 which are isolated from each other by the interlayer dielectric layer 313, that is, by forming split gate electrodes, the parasitic capacitance of the gate electrodes can be reduced.

### Embodiment Three

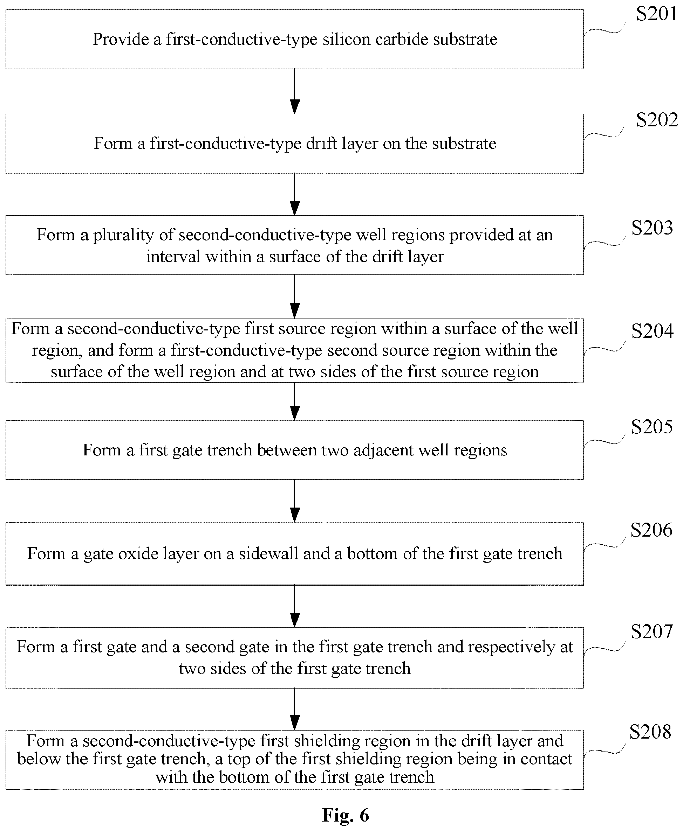

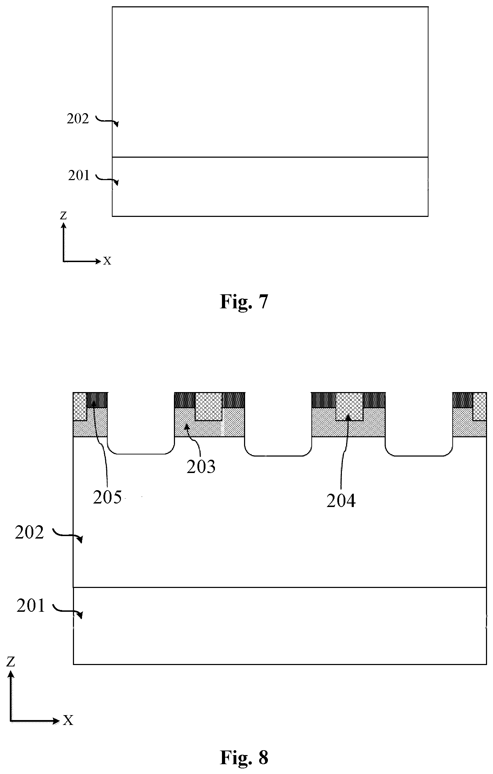

Embodiment Three describes an example not falling under the scope of the claimed invention, having a gate trench with a single width. Based on the embodiment one, the present embodiment provides a preparation method for the cellular structure 200 of the silicon carbide device. Fig. 6 schematically shows a flowchart of a preparation method for the cellular structure 200 of the silicon carbide device according to an embodiment of the present embodiment. Figs. 7 to 13 schematically show sectional views of structures in relevant steps of the preparation method for the cellular structure 200 of the silicon carbide device according to an embodiment of the present embodiment. Detailed steps of an exemplary method of the preparation method for the cellular structure 200 of the silicon carbide device provided in an embodiment of the present embodiment are described with reference to Fig. 6 and Figs. 7 to 13.

As shown in Fig. 6, the preparation method for the cellular structure 200 of the silicon carbide device in the present embodiment includes the following steps.

At step S201, as shown in Fig. 7, a first-conductive-type silicon carbide substrate 201 is provided.

The substrate 201 has a relatively great thickness and a relatively high ion doping concentration greater than 1E19 cm⁻³.

At step S202, a first-conductive-type drift layer 202 is formed on the substrate 201.

Specifically, the drift layer 202 is a uniformly doped silicon carbide layer, and has an ion doping concentration in a range from about 1E14 cm⁻³ to 5E16 cm⁻³, and the ion doping concentration may be optimized according to a withstand voltage of a chip.

At step S203, as shown in Fig. 8, a plurality of second-conductive-type well regions 203 are formed at an interval within a surface of the drift layer 202.

Specifically, second-conductive-type high-energy ions are implanted into the surface of the drift layer 202, so as to form a plurality of second-conductive-type well regions 203 at an interval. An upper surface of the well region 203 is flush with an upper surface of the drift layer 202. The well region 203 has an ion doping concentration in a range from 1E16 cm⁻³ to 5E18 cm⁻³, and has a depth in a range from 0.5 µm to 1.5 µm.

At step S204, a second-conductive-type first source region 204 is formed within a surface of the well region 203, and a first-conductive-type second source region 205 is formed at two sides of the first source region 204 and within the surface of the well region 203.

Specifically, a part of the surface of the well region 203 is selectively shielded by a photoresist by using a photolithography process, and second-conductive-type high-energy ions are implanted into the well region 203 by ion implantation, so as to form the second-conductive-type first source region 204 within the surface of the well region 203. Then, a surface of the first source region 204 is selectively shielded by the photoresist by using a photolithography process. Then, first-conductive-type high-energy ions are implanted into the well region 203 by ion implantation, so as to form the second-conductive-type second source region 205 at the two sides of the first source region 204 and within the surface of the well region 203.

The first source region 204 has an upper surface flush with the upper surface of the well region 203. The first source region 204 has a width less than a width of the well region 203, has an ion doping concentration greater than the ion doping concentration of the well region 203, and has a depth less than or equal to the depth of the well region 203. The ion doping concentration of the first source region 204 is greater than 5E18 cm⁻³, and the depth thereof is in a range from 0.5 µm to 1.5 µm. The second source region 205 has an upper surface flush with the upper surface of the well region 203. The second source region 205 has an ion doping concentration greater than the ion doping concentration of the substrate 201. The second source region 205 has a width less than the width of the well region 203. The ion doping concentration of the second source region 205 is greater than 1E19cm⁻³, and a depth of the second source region 205 is in a range from 0.15 µm to 0.35 µm.

At step S205, a first gate trench (not indicated in the drawings) is formed between two adjacent well regions 203.

Specifically, an area between two adjacent well regions 203 is etched, so as to form the first gate trench between the two adjacent well regions 203. A sidewall of the first gate trench is in contact with both the well region 203 and the second source region 205. The first gate trench has a depth greater than the depth of the well region 203 by 0.2 µm to 0.5 µm. The first gate trench has a width in a range from 1.0 µm to 3.0 µm. The first gate trench has a relatively small depth-to-width ratio, which is convenient for a fabrication process.

It should be noted that, the above steps of forming the well region 203, the first source region 204, the second source region 205, and the first gate trench may alternatively be as follows: forming an entire surface of the well region 203→forming the first source region 204 and the second source region 205 forming the first gate trench by etching.

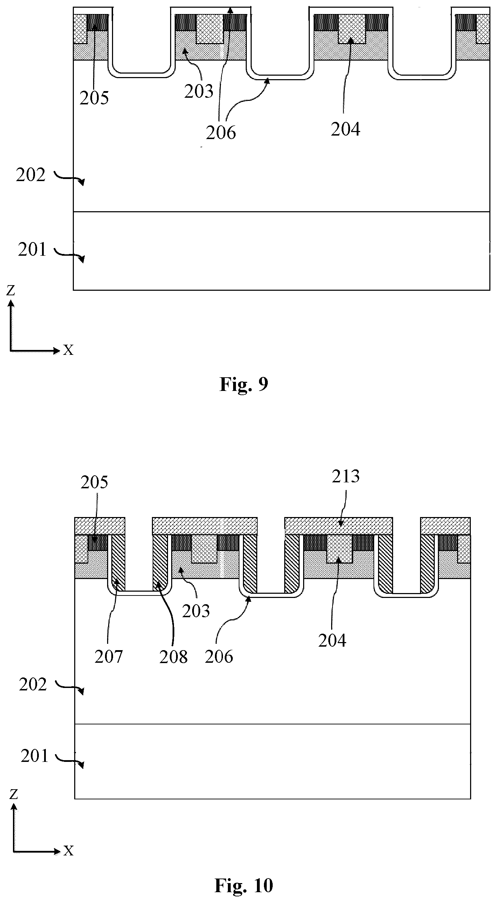

At step S206, as shown in Fig. 9, a gate oxide layer 206 is formed on the sidewall and on a bottom of the first gate trench.

Specifically, step S206 includes the following steps: at step S206a, a sacrificial oxidation treatment is performed on the surface of the drift layer 202 and the sidewall and the bottom of the first gate trench; at step S206b, the gate oxide layer 206 is formed on the drift layer 202 and on the sidewall and the bottom of the first gate trench; and at step S206c, the gate oxide layer 206 on the drift layer 202 is removed by etching.

The sacrificial oxidation treatment includes the following steps: (a) thermal oxidation is performed on the surface of the drift layer 202, so as to form a sacrificial oxidation layer (not shown in the drawing), and the sacrificial oxidation layer has a thickness in a range from 10 nm to 20 nm; and (b) the sacrificial oxidation layer is removed by wet etching.

Similar to the sacrificial oxidation layer, the gate oxide layer 206 is also formed by performing thermal oxidation within a high-temperature (for example, 1300 °C) oxygen atmosphere. The gate oxide layer 206 has a thickness in a range from 30 nm to 100 nm.

At step S207, as shown in Fig. 10, a first gate electrode 207 and a second gate electrode 208 are respectively formed at two sides of the first gate trench in the first gate trench.

Specifically, step S207 includes the following steps: at step S207a, polycrystalline silicon is filled into the first gate trench; at step S207b, a mask layer 213, which covers the first source region 204 and the second source layer 205 and is located on a part of the polycrystalline silicon at two sides of the first gate trench, is formed on the drift layer 202; and at step S207c, the polycrystalline silicon, which is in the first gate trench and not covered by the mask layer 213, is etched, so as to form the first gate electrode 207 and the second gate electrode 208 respectively at the two sides of the first gate trench and in the first gate trench.

It should be noted that, in the present embodiment, after the etching is completed in step S207, the mask layer 213 is not removed.

The polycrystalline silicon filled is high-concentration doped polycrystalline silicon, and has an ion doping concentration greater than 1E18 cm⁻³. A distance between the first gate electrode 207 and the second gate electrode 208 (an etching width) is in a range from 0.5 µm to 2.0 µm. Such a gate electrode with a split structure (including the first gate electrode 207 and the second gate electrode 208) can reduce the parasitic capacitance of the gate electrodes.

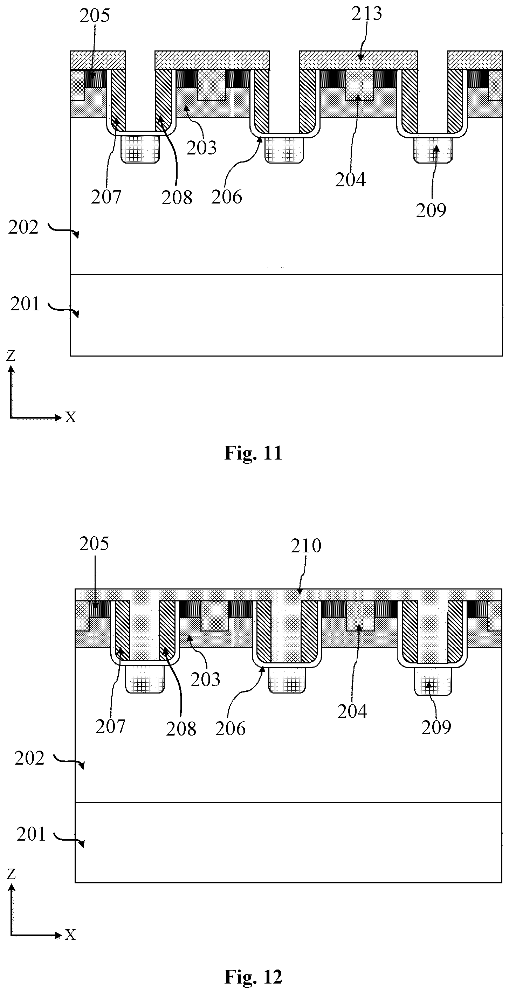

At step S208, as shown in Fig. 11, a second-conductive-type first shielding region 209 is formed below the first gate trench in the drift layer 202, and a top of the first shielding region 209 is in contact with a bottom of the first gate trench.

Specifically, step S208 includes the following steps: at step S208a, through a window formed by the mask layer 213, the first gate electrode 207 and the second gate electrode 208, second-conductive-type high-energy ions are implanted into the drift layer 202 below the first gate trench by self-alignment ion implantation, so as to form the second-conductive-type first shielding region 209; and at step S208b, the mask layer 213 is removed.

The top of the first shielding region 209 is in contact with the bottom of the first gate trench. The first shielding region 209 has an ion doping concentration greater than 1E18 cm⁻³, and has a junction depth (depth) of 1 µm. The first shielding region 209 can greatly reduce the electric field stress of the gate oxide layer 206 of the device in a blocking state, thereby greatly improving the long-term operational reliability of the device.

Moreover, in the present embodiment, the mask layer 213 obtained after the polycrystalline silicon is etched in step S207 is used as the mask layer for ion implantation, and self-alignment ion implantation is performed through the window between the first gate electrode 207 and the second gate electrode 208, which reduces the cost, avoids an influence on a doping concentration of the sidewall of the trench, and further avoids an influence on a threshold voltage of the device.

At step S209, as shown in Fig. 12, an interlayer dielectric layer 210 is formed on the first gate electrode 207 and on the second gate electrode 208 and in the first gate trench. The first gate electrode 207 and the second gate electrode 208 are isolated from each other by the interlayer dielectric layer 210.

The interlayer dielectric layer 210 isolates the first gate electrode 207 and the second gate electrode 208 from the source electrode metal layer 211, and isolates the first gate electrode 207 from the second gate electrode 208, so as to further achieve splitting of the gate electrodes.

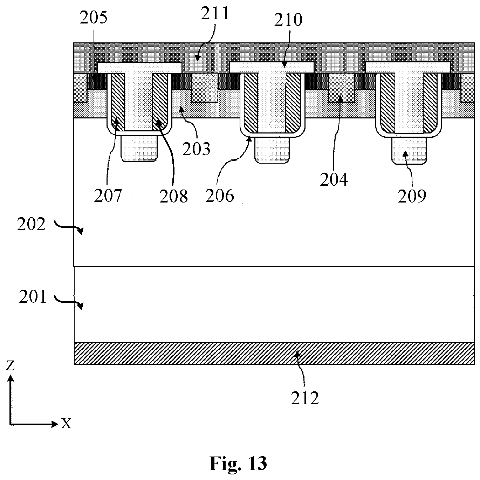

At step S210, as shown in Fig. 13, a source electrode metal layer 211, which is in ohmic contact with both the first source region 204 and the second source region 205, is formed on the first source region 204 and the second source region 205. The first gate electrode 207 and the second gate electrode 208 are isolated from the source electrode metal layer 211 by the interlayer dielectric layer 210, and the first shielding region 209 is in electrical connection with the source electrode metal layer 211 in a three-dimension.

Specifically, the source electrode metal layer 211, which is in ohmic contact with both the first source region 204 and the second source region 205, is formed on the first source region 204 and the second source region 205 by a metallization process.

The source electrode metal layer 211 may be made of a metal having a low contact electrical resistivity, such as aluminum. The first shielding region 209 is in electrical connection (short connection) with a source electrode in a three-dimension. In this way, the first shielding region 209 can greatly reduce the electric field stress of the gate oxide layer 206 of the device in a blocking state, thereby greatly improving the long-term operational reliability of the device.

At step S211, a drain electrode metal layer 212, which is in ohmic contact with the substrate 201, is formed below the substrate 201.

Specifically, a drain electrode metal layer, which is in ohmic contact with the substrate 201, is formed below the substrate 201 by a metallization process. The drain electrode metal layer may be made of a metal having a relatively low contact electrical resistivity, such as aluminum.

Correspondingly, a first conductive type is opposite to a second conductive type. For example, if the first conductive type is an N type, the second conductive type is a P type; and if the first conductive type is a P type, the second conductive type is an N type.

The present embodiment provides a preparation method for a cellular structure 200 of a silicon carbide device. By providing a second-conductive-type first shielding region 209 at a bottom of a first gate trench, the electric field stress of a gate oxide layer 206 of the device in a blocking state can be greatly reduced, thereby greatly improving the long-term operational reliability of the device. Moreover, by providing, in the first gate trench, a first gate electrode 207 and a second gate electrode 208 which are isolated by an interlayer dielectric layer 210, that is, by forming split gate electrodes, the parasitic capacitance of the gate electrodes can be reduced. Moreover, a first shielding region 209 may be formed by a self-alignment ion implantation process using an etched mask of the first gate electrode 207 and the second gate electrode 208, which reduces the cost, avoids an influence on a doping concentration of a sidewall of a trench, and further avoids an influence on a threshold voltage of the device.

### Embodiment Four

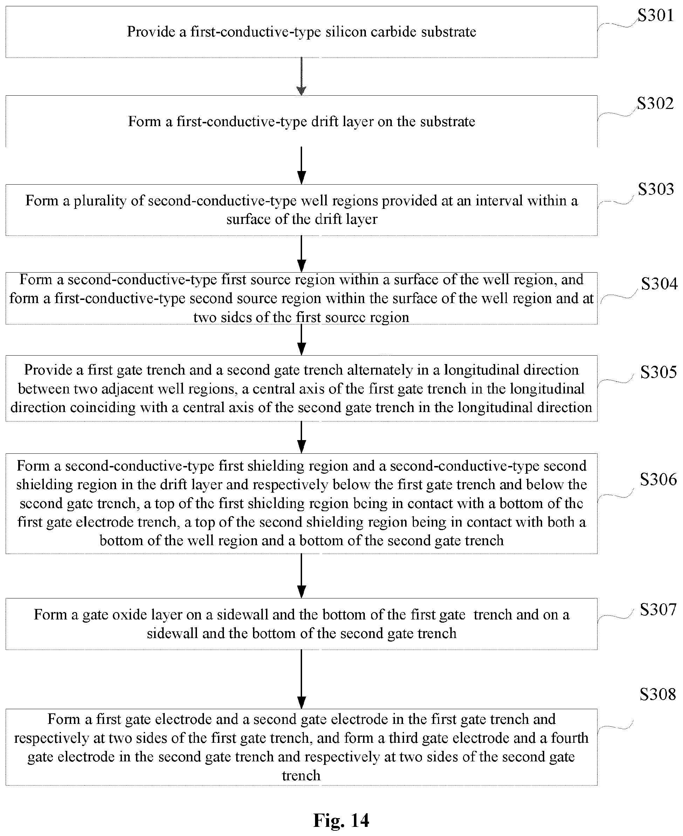

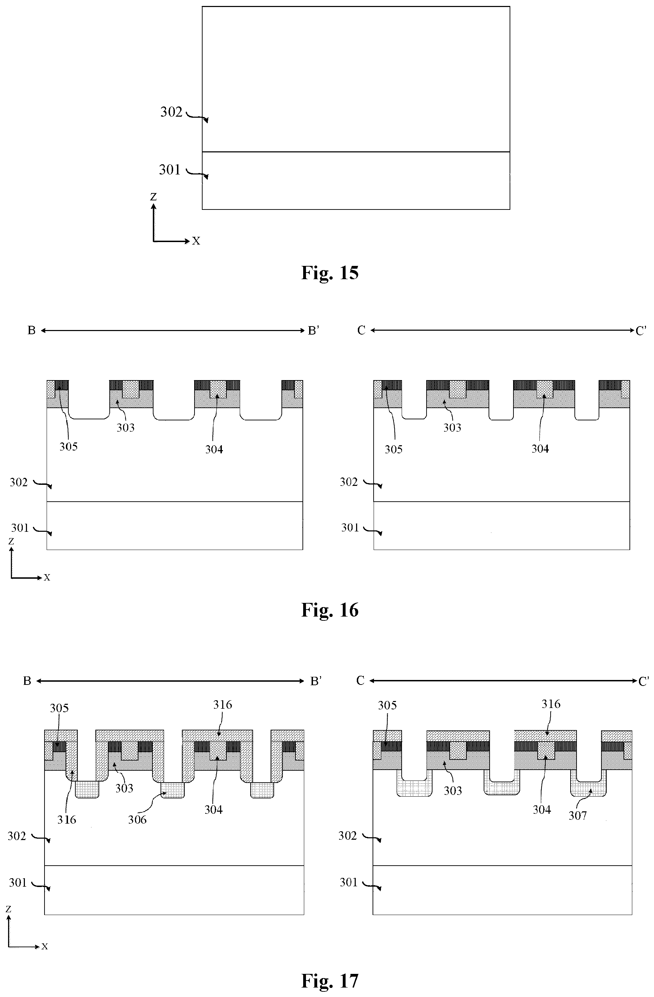

Based on the embodiment two, the present embodiment provides a preparation method for a cellular structure 300 of a silicon carbide device. Fig. 14 schematically shows a flowchart of the preparation method for the cellular structure 300 of the silicon carbide device according to the present embodiment. Figs. 15 to 20 schematically show sectional views of structures in relevant steps of the preparation method for the cellular structure 300 of the silicon carbide device according to the present embodiment. Detailed steps of an exemplary method of the preparation method for the cellular structure 300 of the silicon carbide device provided in the present embodiment are described with reference to Fig. 14 and Figs. 15 to 20

As shown in Fig. 14, the preparation method for the cellular structure 300 of the silicon carbide device in the present embodiment includes the following steps.

At step S301, as shown in Fig. 15, a first-conductive-type silicon carbide substrate 301 is provided.

The substrate 301 has a relatively great thickness and a relatively high ion doping concentration greater than 1E19 cm⁻³.

At step S302, a first-conductive-type drift layer 302 is formed on the substrate 301.

Specifically, the drift layer 302 is a uniformly doped silicon carbide layer, and has an ion doping concentration in a range from about 1E14 cm⁻³ to 5E16 cm⁻³, which may be optimized according to withstand voltage of a chip.

At step S303, as shown in Fig. 16, a plurality of second-conductive-type well regions 303 are formed at an interval within a surface of the drift layer 302.

Specifically, second-conductive-type high-energy ions are implanted into the surface of the drift layer 302, so as to form a plurality of second-conductive-type well regions 303 at an interval from each other. An upper surface of the well region 303 is flush with an upper surface of the drift layer 302. The well region 303 has an ion doping concentration in a range from 1E16 cm⁻³ to 5E18 cm⁻³, and has a depth in a range from 0.5 µm to 1.5 µm.

At step S304, a second-conductive-type first source region 304 is formed within a surface of the well region 303, and a first-conductive-type second source region 305 is formed at two sides of the first source region 304 within the surface of the well region 303.

Specifically, a part of the surface of the well region 303 is selectively shielded by a photoresist by a photolithography process, and second-conductive-type high-energy ions are implanted into the well region 303 by ion implantation, so as to form the second-conductive-type first source region 304 within the surface of the well region 303. Then, a surface of the first source region 304 is selectively shielded by the photoresist and by using the photolithography process. Then, first-conductive-type high-energy ions are implanted into the well region 303 by ion implantation, so as to form the second-conductive-type second source region 305 within the surface of the well region 303 and at the two sides of the first source region 304.

The first source region 304 has an upper surface flush with the upper surface of the well region 303. The first source region 304 has a width less than a width of the well region 303, has an ion doping concentration greater than the ion doping concentration of the well region 303, and has a depth less than or equal to the depth of the well region 303. The ion doping concentration of the first source region 304 is greater than 5E18 cm⁻³, and the depth thereof is in a range from 0.5 µm to 1.5 µm. The second source region 305 has an upper surface flush with the upper surface of the well region 303. The second source region 305 has an ion doping concentration greater than the ion doping concentration of the substrate 301. The second source region 305 has a width less than the width of the well region 303. The ion doping concentration of the second source region 305 is greater than 1E19cm⁻³, and a depth of the second source region 305 is in a range from 0.15 µm to 0.35 µm.

At step S305, a first gate trench and a second gate trench are provided alternately in a longitudinal direction (which is a Y direction) between two adjacent well regions 303. A central axis of the first gate trench in the longitudinal direction coincides with a central axis of the second gate trench in the longitudinal direction.

Specifically, an area between two adjacent well regions 303 are etched, so as to form the first gate trench and the second gate trench alternately in the longitudinal direction (which is the Y direction) between the two adjacent well regions 303. A sidewall of the first gate trench and a sidewall of the second gate trench are in contact with both the well region 303 and the second source region 305. The central axis of the first gate trench in the longitudinal direction (which is the Y direction) coincides with the central axis of the second gate trench in the longitudinal direction (which is the Y direction). Both the first gate trench and the second gate trench have a depth greater than the depth of the well region 303 by 0.2 µm to 0.5 µm. The first gate trench has a width in a range from 1.0 µm to 3.0 µm, and the second gate trench has a width in a range from 0.5 µm to 1.5 µm. The first gate trench has a relatively small depth-to-width ratio, which is convenient for a fabrication process.

It should be noted that the above steps of forming the well region 303, the first source region 304, the second source region 305, the first gate trench, and the second gate trench may also be as follows: forming an entire surface of the well region 303→forming the first source region 304 and the second source region 305→forming the first gate trench and the second gate trench by etching.

At step S306, as shown in Fig. 17, a second-conductive-type first shielding region 306 and a second-conductive-type second shielding region 307 are respectively formed in the drift layer 302 and below the first gate trench and the second gate trench. A top of the first shielding region 306 is in contact with a bottom of the first gate trench, and a top of the second shielding region 307 is in contact with a bottom of the second gate trench and a bottom of the well region 303.

Specifically, step S306 includes the following steps: at step S306a, a mask layer 316, which covers the first source region 304, the second source region 305, and a sidewall of the first gate trench, is formed on the drift layer 302; at step S306b, second-conductive-type high-energy ions are implanted into the drift layer 302 below the first gate trench and the second gate trench, so as to respectively form the second-conductive-type first shielding region 306 and the second-conductive-type second shielding region 307 in the drift layer 302 and below the first gate trench and below the second gate trench; and at step S306c, the mask layer 316 is removed.

Since the sidewall of the first gate trench is covered by the mask layer 316, the second-conductive-type high-energy ions are not implanted into the drift layer 302 beside the sidewall of the first gate trench, so that the first shielding region 306 formed is not in contact with the well region 303. A sidewall of the second gate trench is not covered by the mask layer 316. Accordingly, at the bottom of the second gate trench, the second-conductive-type high-energy ions are scattered into the drift layer 302 beside the sidewall of the second gate trench, so that the top of the second shielding region 307 formed is in contact with the bottom of the well region 303.

The first shielding region 306 and the second shielding region 307 have an ion doping concentration greater than 1E 18cm⁻³, and the first shielding region 306 and the second shielding region 307 have a junction depth (depth) of 1 µm. The first shielding region 306 and the second shielding region 307 can greatly reduce the electric field stress of the gate oxide layer 308 of the device in a blocking state, thereby greatly improving the long-term operational reliability of the device.

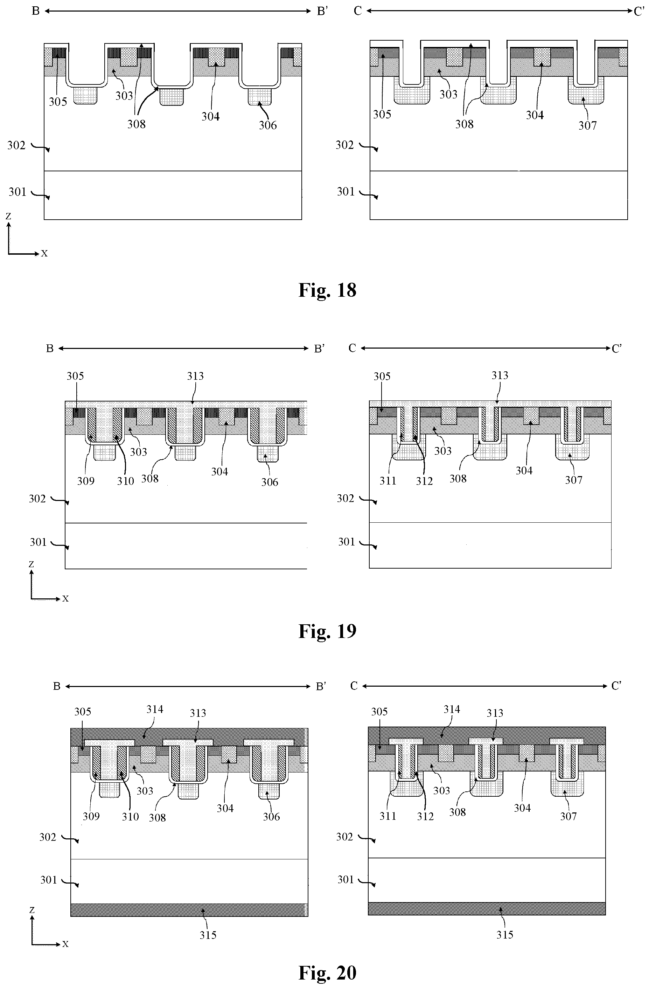

At step S307, as shown in Fig. 18, a gate oxide layer 308 is provided on the sidewall and the bottom of the first gate trench and on the sidewall and the bottom of the second gate trench.

Specifically, step S307 includes the following steps: at step S307a, a sacrificial oxidation treatment is performed on the surface of the drift layer 302, the sidewall and the bottom of the first gate trench, and the sidewall and the bottom of the second gate trench; at step S307b, the gate oxide layer 308 is formed on the drift layer 302, on the sidewall and the bottom of the first gate trench and on the sidewall and the bottom of the second gate trench; and at step S307c, the gate oxide layer 308 on the drift layer 302 is removed by etching.

The sacrificial oxidation treatment includes the following steps: (a) thermal oxidation is performed on the surface of the drift layer 302, so as to form a sacrificial oxidation layer (not shown in the drawing), and the sacrificial oxidation layer has a thickness in a range from 10 nm to 20 nm; and (b) the sacrificial oxidation layer is removed by wet etching.

Similar to the sacrificial oxidation layer, the gate oxide layer 308 is also formed by performing thermal oxidation within a high-temperature (for example, 1300 °C) oxygen atmosphere. The gate oxide layer 308 has a thickness in a range from 30 nm to 100 nm.

At step S308, as shown in Fig. 19, a first gate electrode 309 and a second gate electrode 310 are respectively formed in the first gate trench at two sides of the first gate trench, and a third gate electrode 311 and a fourth gate electrode 312 are respectively formed in the second gate trench at two sides of the second gate electrode.

Specifically, step S308 includes the following steps: at step S308a, polycrystalline silicon is filled into the first gate trench and the second gate trench; at step S308b, a mask layer (not shown in the drawing), which covers the first source region 304 and the second source layer 305 and is located on a part of the polycrystalline silicon at the two sides of the first gate trench and on a part of the polycrystalline silicon at the two sides of the second gate trench, is formed on the drift layer 302; and at step S308c, polycrystalline silicon, which is in the first gate trench and the second gate trench and not covered by the mask layer (not shown in the drawing), is etched, so as to form the first gate electrode 309 and the second gate electrode 310 in the first gate trench respectively at the two sides of the first gate trench and form the third gate electrode 311 and the fourth gate electrode 312 in the second gate trench respectively at the two sides of the second gate trench.

The polycrystalline silicon filled is high-concentration doped polycrystalline silicon, and has an ion doping concentration greater than 1E18 cm⁻³. A distance between the first gate electrode 309 and the second gate electrode 310 (an etching width) is in a range from 0.5 µm to 2.0 µm. A distance between the third gate electrode 311 and the fourth gate electrode 312 is less than the distance between the first gate electrode 309 and the second gate electrode 310. Such a gate electrode with a split structure can reduce the parasitic capacitance of the gate electrode.

At step S309, an interlayer dielectric layer 313 is formed on the first gate electrode 309, the second gate electrode 310, the third gate electrode 311, and the fourth gate electrode 312 and in the first gate trench and the second gate trench. The first gate electrode 309 and the second gate electrode 310 are isolated by the interlayer dielectric layer 313, and the third gate electrode 311 and the fourth gate electrode 312 are isolated by the interlayer dielectric layer 313.

The interlayer dielectric layer 313 isolates the first gate electrode 309 from the second gate electrode 310, and isolates the third gate electrode 311 from the fourth gate electrode 312, so as to further achieve splitting of the gate electrodes.

At step S310, as shown in Fig. 20, a source electrode metal layer 314, which is in ohmic contact with both the first source region 304 and the second source region 305, is formed on the first source region 304 and the second source region 305. The first gate electrode 309, the second gate electrode 310, the third gate electrode 311, and the fourth gate electrode 312 are isolated from the source electrode metal layer 314 by the interlayer dielectric layer 313. The first shielding region 306 and the second shielding region 307 are in electric connection with the source electrode metal layer 314 in a three-dimension.

Specifically, the source electrode metal layer 314, which is in ohmic contact with both the first source region 304 and the second source region 305, is formed on the first source region 304 and the second source region 305 by a metallization process.

The source electrode metal layer 314 may be made of a metal having a low contact electrical resistivity, such as aluminum. The first shielding region 306 and the second shielding region 307 are in electric connection (short connection) with a source electrode in a three-dimension. In this way, the first shielding region 306 and the second shielding region 307 can greatly reduce the electric field stress of the gate oxide layer 308 of the device in a blocking state, thereby greatly improving the long-term operational reliability of the device.

At step S311, a drain electrode metal layer 315, which is in ohmic contact with the substrate 301, is formed below the substrate 301.

Specifically, a drain electrode metal layer, which is in ohmic contact with the substrate 301, is formed below the substrate 301 by a metallization process. The drain electrode metal layer may be made of a metal having a relatively low contact electrical resistivity, such as aluminum.

Correspondingly, a first conductive type is opposite to a second conductive type. For example, if the first conductive type is an N type, the second conductive type is a P type; and if the first conductive type is a P type, the second conductive type is an N type.

The present embodiment provides a preparation method for a cellular structure 300 of a silicon carbide device. By providing a second-conductive-type first shielding region 306 at a bottom of a first gate trench and providing a second-conductive-type second shielding region 307 at a bottom of a second gate trench, the electric field stress of a gate oxide layer 308 of the device in a blocking state can be greatly reduced, thereby greatly improving the long-term operational reliability of the device. Moreover, by providing, in the first gate trench, a first gate electrode 309 and a second gate electrode 310 which are isolated from each other by an interlayer dielectric layer 313, and providing, in the second gate trench, a third gate electrode 311 and a fourth gate electrode 312 which are isolated from each other by the interlayer dielectric layer 313, that is, by forming split gate electrodes, the parasitic capacitance of the gate electrodes can be reduced.

The above content involves preferred embodiments of the present disclosure, but the scope of protection of the present invention is only determined by the scope as defined in the claims.

## Claims

1. A cellular structure of a silicon carbide device, comprising:
a first-conductive-type silicon carbide substrate (301);
a first-conductive-type drift layer (302) located on the substrate;
a plurality of second-conductive-type well regions (303) provided at an interval within a surface of the drift layer (302);
a second-conductive-type body contact region (304) located within a surface of the well region, and first-conductive-type source regions (305) located within the surface of the well region and at two sides of the body contact region (304);
a first gate trench and a second gate trench, a width of the first trench being larger than that of the second trench, each trench having a longitudinal direction along a length of the trench, the first gate trench and the second gate trench being provided alternately in said longitudinal direction between two adjacent well regions (303), the first and second gate trenches being continuous, **characterised in that** the sidewalls of the first gate trench are in contact with both the adjacent well regions (303) and second source regions (305) in the adjacent well regions, and sidewalls of the second gate trench are in contact with both the adjacent well regions (303) and the source regions (305) in the adjacent well regions, and a central axis of the first gate trench in the longitudinal direction coincides with a central axis of the second gate trench in the longitudinal direction, the adjacent well regions at both sides of the first gate trench and the adjacent well regions at both sides of the second gate trench have, respectively, a structure that a body contact region (304) is located within the surface of a well region and source regions (305) are located within the surface of the well region and at two sides of the body contact region (304), the well region, the body contact region and the source region being continuous in the direction along the sidewalls of the first and second gate trench;
a second-conductive-type first shielding region (306) and a second-conductive-type second shielding region (307) located in the drift layer (302) and respectively located below the first gate trench and below the second gate trench, wherein a top of the first shielding region (306) is in contact with a bottom of the first gate trench and not in contact with bottoms of the well regions (303), and a top of the second shielding region (307) is in contact with both the bottoms of the well regions and a bottom of the second gate trench;
a gate oxide layer (308) provided on the sidewalls and the bottom of the first gate trench and on the sidewalls and the bottom of the second gate trench; and
a first gate electrode (309) and a second gate electrode (310) provided in the first gate trench and respectively at two sides of the first gate trench, and a third gate electrode (311) and a fourth gate electrode (312) provided in the second gate trench and respectively at two sides of the second gate trench, wherein the first gate electrode and the second gate electrode are isolated by the interlayer dielectric layer (313), and the third gate electrode and the fourth gate electrode are isolated by the interlayer dielectric layer (313).

2. The cellular structure of a silicon carbide device according to claim 1, wherein
the first gate trench has a width in a range from 1.0 µm to 3.0 µm;
the second gate trench has a width in a range from 0.5 µm to 1.5 µm; and
the first gate trench and the second gate trench have a depth greater than a depth of the well region by 0.2 µm to 0.5 µm.

3. The cellular structure of a silicon carbide device according to claim 1, wherein
the first shielding region and the second shielding region have an ion doping concentration greater than 5E18cm⁻³, and
the first shielding region and the second shielding region has a depth in a range from 0.5 µm to 1.5 µm.

4. The cellular structure of a silicon carbide device according to claim 1, further comprising:
a source electrode metal layer (314) located on the body contact region and the source regions and in ohmic contact with both the body contact region and the source regions, wherein the first gate electrode (309), the second gate electrode (310), the third gate electrode (311), and the fourth gate electrode (312) are isolated from the source electrode metal layer by the interlayer dielectric layer (313), and the first shielding region and the second shielding region are in electric connection with the source electrode metal layer (314) in a three-dimension; and
a drain electrode metal layer (315) located below the substrate and in ohmic contact with the substrate.

5. A preparation method for the cellular structure of a silicon carbide device according to any one of claims 1 to 4, comprising:
providing a first-conductive-type silicon carbide substrate (301);
forming a first-conductive-type drift layer (302) on the substrate;
forming a plurality of second-conductive-type well regions (303) at an interval within a surface of the drift layer;
forming a second-conductive-type body contact region (304) within a surface of the well region, and forming first-conductive-type source regions (305) within the surface of the well region and at two sides of the body contact region (304);
providing a first gate trench and a second gate trench alternately in a longitudinal direction between two adjacent well regions (303), a width of the first trench being larger than that of the second trench, and the first and second gate trenches being continuous, wherein a central axis of the first gate trench in the longitudinal direction coincides with a central axis of the second gate trench in the longitudinal direction;
forming a second-conductive-type first shielding region (306) and a second-conductive-type second shielding region (307) in the drift layer and respectively below the first gate trench and below the second gate trench, wherein a top of the first shielding region (306) is in contact with a bottom of the first gate trench and not in contact with bottoms of the well regions (303), and a top of the second shielding region is in contact with both the bottom of the well regions and a bottom of the second gate trench;
forming a gate oxide layer (308) on sidewalls and the bottom of the first gate trench and on sidewalls and the bottom of the second gate trench; and
forming a first gate electrode (309) and a second gate electrode (310) in the first gate trench and respectively at two sides of the first gate trench, and forming a third gate electrode (311) and a fourth gate electrode (312) in the second gate trench and respectively at two sides of the second gate trench.

6. The preparation method for the cellular structure of a silicon carbide device according to claim 5, wherein the forming the second-conductive-type first shielding region and the second-conductive-type second shielding region in the drift layer and respectively below the first gate trench and below the second gate trench comprises:
forming a mask layer (316), which covers the body contact region (304), the source regions (305), and the sidewalls of the first gate trench;
implanting second-conductive-type high-energy ions into the drift layer (302) below the first gate trench and below the second gate trench, so as to form the second-conductive-type first shielding region (306) and the second-conductive-type second shielding region (307) respectively below the first gate trench and below the second gate trench; and
removing the mask layer (316),
wherein after the forming the first gate electrode (309) and the second gate electrode (310) in the first gate trench and respectively at the two sides of the first gate trench, and the forming the third gate electrode (311) and the fourth gate electrode (312) in the second gate trench and respectively at the two sides of the second gate trench, and
forming an interlayer dielectric layer (313) on the first gate electrode, the second gate electrode, the third gate electrode, and the fourth gate electrode, and in the first gate trench and the second gate trench, wherein the first gate electrode and the second gate electrode are isolated by the interlayer dielectric layer, and the third gate electrode and the fourth gate electrode are isolated by the interlayer dielectric layer.
forming a source electrode metal layer (314), which is in ohmic contact with both the body contact region (304) and the source regions (305), on the body contact region and the source regions, wherein the first gate electrode, the second gate electrode, the third gate electrode, and the fourth gate electrode are isolated from the source electrode metal layer by the interlayer dielectric layer, and the first shielding region and the second shielding region are in electric connection with the source electrode metal layer in a three-dimension; and
forming a drain electrode metal layer, which is in ohmic contact with the substrate, below the substrate.

7. A silicon carbide device, comprising several cellular structures of a silicon carbide device according to any one of claims 1 to 4.

## Patentansprüche

1. Zellulare Struktur einer Siliciumcarbid-Vorrichtung, umfassend:
ein Siliciumcarbid-Substrat (301) des ersten Leitfähigkeitstyps;
eine Driftschicht (302) des ersten Leitfähigkeitstyps, die auf dem Substrat angeordnet ist;
eine Vielzahl von Wannenbereichen (303) des zweiten Leitfähigkeitstyps, die in einem Abstand innerhalb einer Oberfläche der Driftschicht (302) vorgesehen sind;
einen Körperkontaktbereich (304) des zweiten Leitfähigkeitstyps, der innerhalb einer Oberfläche des Wannenbereichs angeordnet ist, und Source-Bereiche (305) des ersten Leitfähigkeitstyps, die innerhalb der Oberfläche des Wannenbereichs und auf zwei Seiten des Körperkontaktbereichs (304) angeordnet sind;
einen ersten Gate-Graben und einen zweiten Gate-Graben, wobei eine Breite des ersten Grabens größer ist als diejenige des zweiten Grabens, jeder Graben eine Längsrichtung entlang einer Länge des Grabens aufweist, der erste Gate-Graben und der zweite Gate-Graben in der Längsrichtung zwischen zwei angrenzenden Wannenbereichen (303) abwechselnd vorgesehen sind, wobei der erste und der zweite Gate-Graben durchgehend sind, **dadurch gekennzeichnet, dass** die Seitenwände des ersten Gate-Grabens sowohl mit den angrenzenden Wannenbereichen (303) als auch mit zweiten Source-Bereichen (305) in den angrenzenden Wannenbereichen im Kontakt stehen, und Seitenwände des zweiten Gate-Grabens sowohl mit den angrenzenden Wannenbereichen (303) als auch mit den Source-Bereichen (305) in den angrenzenden Wannenbereichen im Kontakt stehen, und eine Mittelachse des ersten Gate-Grabens in der Längsrichtung mit einer Mittelachse des zweiten Gate-Grabens in der Längsrichtung übereinstimmt, die angrenzenden Wannenbereiche auf beiden Seiten des ersten Gate-Grabens und die angrenzenden Wannenbereiche auf beiden Seiten des zweiten Gate-Grabens jeweils eine derartige Struktur haben, dass ein Körperkontaktbereich (304) innerhalb der Oberfläche eines Wannenbereichs angeordnet ist und Source-Bereiche (305) innerhalb der Oberfläche des Wannenbereichs und auf zwei Seiten des Körperkontaktbereichs (304) angeordnet sind, wobei der Wannenbereich, der Körperkontaktbereich und der Source-Bereich durchgehend in der Richtung entlang der Seitenwände des ersten und des zweiten Gate-Grabens sind;
einen ersten Abschirmungsbereich (306) des zweiten Leitfähigkeitstyps und einen zweiten Abschirmungsbereich (307) des zweiten Leitfähigkeitstyps, die in der Driftschicht (302) und jeweils unter dem ersten Gate-Graben und unter dem zweiten Gate-Graben angeordnet sind, worin ein Oberteil des ersten Abschirmungsbereichs (306) mit einem Unterteil des ersten Gate-Grabens im Kontakt steht und mit Unterteilen der Wannenbereiche (303) in keinem Kontakt steht, und ein Oberteil des zweiten Abschirmungsbereichs (307) sowohl mit den Unterteilen der Wannenbereiche und einem Unterteil des zweiten Gate-Grabens im Kontakt steht;
eine Gate-Oxidschicht (308), die an den Seitenwänden und an dem Unterteil des ersten Gate-Grabens und an den Seitenwänden und an dem Unterteil des zweiten Gate-Grabens vorgesehen ist; und
eine erste Gate-Elektrode (309) und eine zweite Gate-Elektrode (310), die in dem ersten Gate-Graben und jeweils an zwei Seiten des ersten Gate-Grabens vorgesehen sind, und eine dritte Gate-Elektrode (311) und eine vierte Gate-Elektrode (312), die in dem zweiten Gate-Graben und jeweils an zwei Seiten des zweiten Gate-Grabens vorgesehen sind, worin die erste Gate-Elektrode und die zweite Gate-Elektrode durch die Zwischenschicht-Dielektrikumschicht (313) isoliert sind, und die dritte Gate-Elektrode und die vierte Gate-Elektrode durch die Zwischenschicht-Dielektrikumschicht (313) isoliert sind.

2. Zellulare Struktur einer Siliciumcarbid-Vorrichtung nach Anspruch 1, worin
der erste Gate-Graben eine Breite in einem Bereich von 1.0 µm bis 3.0 µm hat;
der zweite Gate-Graben eine Breite in einem Bereich von 0.5 µm bis 1.5 µm hat; und
der erste Gate-Graben und der zweite Gate-Graben eine größere Tiefe haben als eine Tiefe des Wannenbereichs um 0.2 µm bis 0.5 µm.

3. Zellulare Struktur einer Siliciumcarbid-Vorrichtung nach Anspruch 1, worin
der erste Abschirmungsbereich und der zweite Abschirmungsbereich eine Ionendotierungskonzentration größer als 5E18cm⁻³ haben, und
der erste Abschirmungsbereich und der zweite Abschirmungsbereich eine Tiefe in einem Bereich von 0.5 µm bis 1.5 µm haben.

4. Zellulare Struktur einer Siliciumcarbid-Vorrichtung nach Anspruch 1, ferner umfassend:
eine Source-Elektrode-Metallschicht (314), die auf dem Körperkontaktbereich und den Source-Bereichen angeordnet ist und in ohmischem Kontakt sowohl mit dem Körperkontaktbereich als auch mit den Source-Bereichen steht,
worin die erste Gate-Elektrode (309), die zweite Gate-Elektrode (310), die dritte Gate-Elektrode (311) und die vierte Gate-Elektrode (312) von der Source-Elektrode-Metallschicht durch die Zwischenschicht-Dielektrikumschicht (313) isoliert sind, und der erste Abschirmungsbereich und der zweite Abschirmungsbereich mit der Source-Elektrode-Metallschicht (314) in einer Dreidimension in elektrischer Verbindung stehen; und
eine Drain-Elektrode-Metallschicht (315), die unter dem Substrat angeordnet ist und mit dem Substrat in ohmischem Kontakt steht.

5. Herstellungsverfahren für die zellulare Struktur einer Siliciumcarbid-Vorrichtung nach einem der Ansprüche 1 bis 4, umfassend:
Bereitstellen eines Siliciumcarbid-Substrats (301) des ersten Leitfähigkeitstyps;
Bilden einer Driftschicht (302) des ersten Leitfähigkeitstyps auf dem Substrat;
Bilden einer Vielzahl von Wannenbereichen (303) des zweiten Leitfähigkeitstyps in einem Abstand innerhalb einer Oberfläche der Driftschicht;
Bilden eines Körperkontaktbereichs (304) des zweiten Leitfähigkeitstyps innerhalb einer Oberfläche des Wannenbereichs, und Bilden von Source-Bereichen (305) des ersten Leitfähigkeitstyps innerhalb der Oberfläche des Wannenbereichs und auf zwei Seiten des Körperkontaktbereichs (304);
Bereitstellen eines ersten Gate-Grabens und eines zweiten Gate-Grabens abwechselnd in einer Längsrichtung zwischen zwei angrenzenden Wannenbereichen (303), wobei eine Breite des ersten Grabens größer ist als diejenige des zweiten Grabens, und der erste und der zweite Gate-Graben durchgehend sind, worin eine Mittelachse des ersten Gate-Grabens in der Längsrichtung mit einer Mittelachse des zweiten Gate-Grabens in der Längsrichtung übereinstimmt;
Bilden eines ersten Abschirmungsbereichs (306) des zweiten Leitfähigkeitstyps und eines zweiten Abschirmungsbereichs (307) des zweiten Leitfähigkeitstyps in der Driftschicht und jeweils unter dem ersten Gate-Graben und unter dem zweiten Gate-Graben, worin ein Oberteil des ersten Abschirmungsbereichs (306) mit einem Unterteil des ersten Gate-Grabens im Kontakt steht und mit Unterteilen der Wannenbereiche (303) in keinem Kontakt steht, und ein Oberteil des zweiten Abschirmungsbereichs sowohl mit den Unterteilen der Wannenbereiche und einem Unterteil des zweiten Gate-Grabens im Kontakt steht;
Bilden einer Gate-Oxidschicht (308) an Seitenwänden und an dem Unterteil des ersten Gate-Grabens und an Seitenwänden und an dem Unterteil des zweiten Gate-Grabens; und
Bilden einer ersten Gate-Elektrode (309) und einer zweiten Gate-Elektrode (310) in dem ersten Gate-Graben und jeweils an zwei Seiten des ersten Gate-Grabens, und Bilden einer dritten Gate-Elektrode (311) und einer vierten Gate-Elektrode (312) in dem zweiten Gate-Graben und jeweils an zwei Seiten des zweiten Gate-Grabens.

6. Herstellungsverfahren für die zellulare Struktur einer Siliciumcarbid-Vorrichtung nach Anspruch 5, worin das Bilden des ersten Abschirmungsbereichs des zweiten Leitfähigkeitstyps und des zweiten Abschirmungsbereichs des zweiten Leitfähigkeitstyps in der Driftschicht und jeweils unter dem ersten Gate-Graben und unter dem zweiten Gate-Graben umfasst:
Bilden einer Maskenschicht (316), die den Körperkontaktbereich (304), die Source-Bereiche (305) und die Seitenwände des ersten Gate-Grabens abdeckt;
Implantieren von energiereichen Ionen des zweiten Leitfähigkeitstyps in die Driftschicht (302) unter dem ersten Gate-Graben und unter dem zweiten Gate-Graben, so dass der erste Abschirmungsbereich (306) des zweiten Leitfähigkeitstyps und der zweite Abschirmungsbereich (307) des zweiten Leitfähigkeitstyps jeweils unter dem ersten Gate-Graben und unter dem zweiten Gate-Graben gebildet werden; und
Entfernen der Maskenschicht (316),
worin nach dem Bilden der ersten Gate-Elektrode (309) und der zweiten Gate-Elektrode (310) in dem ersten Gate-Graben und jeweils an zwei Seiten des ersten Gate-Grabens, und dem Bilden der dritten Gate-Elektrode (311) und der vierten Gate-Elektrode (312) in dem zweiten Gate-Graben und jeweils an den zwei Seiten des zweiten Gate-Grabens, und
Bilden einer Zwischenschicht-Dielektrikumschicht (313) auf der ersten Gate-Elektrode, der zweiten Gate-Elektrode, der dritten Gate-Elektrode und der vierten Gate-Elektrode, und in dem ersten Gate-Graben und in dem zweiten Gate-Graben, worin die erste Gate-Elektrode und die zweite Gate-Elektrode durch die Zwischenschicht-Dielektrikumschicht isoliert sind, und die dritte Gate-Elektrode und die vierte Gate-Elektrode durch die Zwischenschicht-Dielektrikumschicht isoliert sind.
Bilden einer Source-Elektrode-Metallschicht (314), die in ohmischem Kontakt sowohl mit dem Körperkontaktbereich (304) als auch mit den Source-Bereichen (305) steht, auf dem Körperkontaktbereich und den Source-Bereichen, worin die erste Gate-Elektrode, die zweite Gate-Elektrode, die dritte Gate-Elektrode und die vierte Gate-Elektrode von der Source-Elektrode-Metallschicht durch die Zwischenschicht-Dielektrikumschicht isoliert sind, und der erste Abschirmungsbereich und der zweite Abschirmungsbereich mit der Source-Elektrode-Metallschicht in einer Dreidimension in elektrischer Verbindung stehen; und
Bilden einer Drain-Elektrode-Metallschicht, die mit dem Substrat in ohmischem Kontakt steht, unter dem Substrat.

7. Siliciumcarbid-Vorrichtung, umfassend mehrere zellulare Strukturen einer Siliciumcarbid-Vorrichtung nach einem der Ansprüche 1 bis 4.

## Revendications

1. Structure cellulaire d'un dispositif en carbure de silicium, comprenant :
un substrat de carbure de silicium de premier type conducteur (301) ;
une couche de dérive de premier type conducteur (302) située sur le substrat ;
une pluralité de régions de puits de second type conducteur (303) prévues à un intervalle à l'intérieur d'une surface de la couche de dérive (302) ;
une région de contact de corps de second type conducteur (304) située à l'intérieur d'une surface de la région de puits, et des régions de source de premier type conducteur (305) situées à l'intérieur de la surface de la région de puits et sur deux côtés de la région de contact de corps (304) ;
une première tranchée de grille et une seconde tranchée de grille, une largeur de la première tranchée étant plus grande que celle de la seconde tranchée, chaque tranchée ayant une direction longitudinale le long d'une longueur de la tranchée, la première tranchée de grille et la seconde tranchée de grille étant prévues alternativement dans ladite direction longitudinale entre deux régions de puits adjacentes (303), les première et seconde tranchées de grille étant continues, **caractérisé en ce que** les parois latérales de la première tranchée de grille sont en contact avec les deux régions de puits adjacentes (303) et des secondes régions de source (305) dans les régions de puits adjacentes, et les parois latérales de la seconde tranchée de grille sont en contact à la fois avec les régions de puits adjacentes (303) et les régions de source (305) dans les régions de puits adjacentes, et un axe central de la première tranchée de grille dans la direction longitudinale coïncide avec un axe central de la seconde tranchée de grille dans la direction longitudinale, les régions de puits adjacentes des deux côtés de la première tranchée de grille et les régions de puits adjacentes des deux côtés de la seconde tranchée de grille ont, respectivement, une structure selon laquelle une région de contact de corps (304) est située à l'intérieur de la surface d'une région de puits et des régions de source (305) sont situées à l'intérieur de la surface de la région de puits et au niveau de deux côtés de la région de contact de corps (304), la région de puits, la région de contact de corps et la région de source étant continues dans la direction le long des parois latérales des première et seconde tranchées de grille ;
une première région de blindage de second type conducteur (306) et une seconde région de blindage de second type conducteur (307) situées dans la couche de dérive (302) et respectivement situées en dessous de la première tranchée de grille et en dessous de la seconde tranchée de grille, dans lequel un sommet de la première région de blindage (306) est en contact avec un fond de la première tranchée de grille et n'est pas en contact avec des fonds des régions de puits (303), et un sommet de la seconde région de blindage (307) est en contact à la fois avec les fonds des régions de puits et avec un fond de la seconde tranchée de grille ;
une couche d'oxyde de grille (308) prévue sur les parois latérales et le fond de la première tranchée de grille et sur les parois latérales et le fond de la seconde tranchée de grille ; et
une première électrode de grille (309) et une deuxième électrode de grille (310) prévues dans la première tranchée de grille et respectivement sur deux côtés de la première tranchée de grille, et une troisième électrode de grille (311) et une quatrième électrode de grille (312) prévues dans la seconde tranchée de grille et respectivement sur deux côtés de la seconde tranchée de grille, dans lequel la première électrode de grille et la deuxième électrode de grille sont isolées par la couche diélectrique intercouche (313), et la troisième électrode de grille et la quatrième électrode de grille sont isolées par la couche diélectrique intercouche (313).

2. Structure cellulaire d'un dispositif en carbure de silicium selon la revendication 1, dans laquelle
la première tranchée de grille a une largeur comprise dans une plage de 1.0 µm à 3.0 µm ;
la seconde tranchée de grille a une largeur comprise dans une plage de 0.5 µm à 1.5 µm ; et
la première tranchée de grille et la seconde tranchée de grille ont une profondeur supérieure à une profondeur de la région de puits de 0.2 µm à 0.5 µm.

3. Structure cellulaire d'un dispositif en carbure de silicium selon la revendication 1, dans laquelle
la première région de blindage et la seconde région de blindage ont une concentration de dopage ionique supérieure à 5E18cm⁻³, et
la première région de blindage et la seconde région de blindage ont une profondeur comprise dans une plage de 0.5 µm à 1.5 µm.

4. Structure cellulaire d'un dispositif en carbure de silicium selon la revendication 1, comprenant en outre :
une couche métallique d'électrode de source (314) située sur la région de contact de corps et les régions de source et en contact ohmique à la fois avec la région de contact de corps et les régions de source,
dans lequel la première électrode de grille (309), la deuxième électrode de grille (310), la troisième électrode de grille (311) et la quatrième électrode de grille (312) sont isolées de la couche métallique d'électrode de source par la couche diélectrique intercouche (313), et la première région de blindage et la seconde région de blindage sont en connexion électrique avec la couche métallique d'électrode de source (314) en trois dimensions ; et
une couche métallique d'électrode de drain (315) située sous le substrat et en contact ohmique avec le substrat.

5. Procédé de préparation pour la structure cellulaire d'un dispositif en carbure de silicium selon l'une quelconque des revendications 1 à 4, comprenant :
la fourniture d'un substrat de carbure de silicium de premier type conducteur (301) ;
la formation d'une couche de dérive de premier type conducteur (302) sur le substrat ;
la formation d'une pluralité de régions de puits de second type conducteur (303) à un intervalle à l'intérieur d'une surface de la couche de dérive ;
la formation d'une région de contact de corps de second type conducteur (304) à l'intérieur d'une surface de la région de puits, et la formation des régions de source de premier type conducteur (305) à l'intérieur de la surface de la région de puits et de deux côtés de la région de contact de corps (304) ;
la fourniture d'une première tranchée de grille et d'une seconde tranchée de grille alternativement dans une direction longitudinale entre deux régions de puits adjacentes (303), une largeur de la première tranchée étant plus grande que celle de la seconde tranchée, et les première et seconde tranchées de grille étant continues, dans lequel un axe central de la première tranchée de grille dans la direction longitudinale coïncide avec un axe central de la seconde tranchée de grille dans la direction longitudinale ;
la formation d'une première région de blindage de second type conducteur (306) et une seconde région de blindage de second type conducteur (307) dans la couche de dérive et respectivement en dessous de la première tranchée de grille et en dessous de la seconde tranchée de grille, dans lequel un sommet de la première région de blindage (306) est en contact avec un fond de la première tranchée de grille et n'est pas en contact avec des fonds des régions de puits (303), et un sommet de la seconde région de blindage est en contact à la fois avec le fond des régions de puits et avec un fond de la seconde tranchée de grille ;
la formation d'une couche d'oxyde de grille (308) sur les parois latérales et le fond de la première tranchée de grille et sur les parois latérales et le fond de la seconde tranchée de grille ; et
la formation d'une première électrode de grille (309) et d'une deuxième électrode de grille (310) dans la première tranchée de grille et respectivement sur deux côtés de la première tranchée de grille, et la formation d'une troisième électrode de grille (311) et d'une quatrième électrode de grille (312) dans la seconde tranchée de grille et respectivement sur deux côtés de la seconde tranchée de grille.

6. Procédé de préparation de la structure cellulaire d'un dispositif en carbure de silicium selon la revendication 5, dans lequel la formation de la première région de blindage de second type conducteur et de la seconde région de blindage de second type conducteur dans la couche de dérive et respectivement en dessous de la première tranchée de grille et en dessous de la seconde tranchée de grille comprend :
la formation d'une couche de masque (316), qui recouvre la région de contact de corps (304), les régions de source (305) et les parois latérales de la première tranchée de grille ;
l'implantation des ions de haute énergie de second type conducteur dans la couche de dérive (302) en dessous de la première tranchée de grille et en dessous de la seconde tranchée de grille, de manière à former la première région de blindage de second type conducteur (306) et la seconde région de blindage de second type conducteur (307) respectivement en dessous de la première tranchée de grille et en dessous de la seconde tranchée de grille ; et
le retrait de la couche de masque (316),
dans lequel, après la formation de la première électrode de grille (309) et de la deuxième électrode de grille (310) dans la première tranchée de grille et respectivement des deux côtés de la première tranchée de grille, et la formation de la troisième électrode de grille (311) et de la quatrième électrode de grille (312) dans la seconde tranchée de grille et respectivement des deux côtés de la seconde tranchée de grille, et
la formation d'une couche diélectrique intercouche (313) sur la première électrode de grille, la deuxième électrode de grille, la troisième électrode de grille et la quatrième électrode de grille, et dans la première tranchée de grille et la seconde tranchée de grille, dans lequel la première électrode de grille et la deuxième électrode de grille sont isolées par la couche diélectrique intercouche, et la troisième électrode de grille et la quatrième électrode de grille sont isolées par la couche diélectrique intercouche.
la formation d'une couche métallique d'électrode de source (314), qui est en contact ohmique à la fois avec la région de contact de corps (304) et les régions de source (305), sur la région de contact de corps et les régions de source, dans lequel la première électrode de grille, la deuxième électrode de grille, la troisième électrode de grille et la quatrième électrode de grille sont isolées de la couche métallique d'électrode de source par la couche diélectrique intercouche, et la première région de blindage et la seconde région de blindage sont en connexion électrique avec la couche métallique d'électrode de source en trois dimensions ; et
la formation d'une couche métallique d'électrode de drain, qui est en contact ohmique avec le substrat, sous le substrat.

7. Dispositif en carbure de silicium, comprenant différentes structures cellulaires d'un dispositif en carbure de silicium selon l'une quelconque des revendications 1 à 4.
